# EUROPÄISCHE PATENTSCHRIFT

(11) **EP 3 094 697 B1**
(45) Veröffentlichungstag und Bekanntmachung des Hinweises auf die Patenterteilung: **04.04.2018**
(21) Anmeldenummer: 14805622.9
(22) Anmeldetag: 02.12.2014
(51) Int. Cl.: C09D 183/04, H01L 23/26

(54) **SCHALTUNGSTRÄGER MIT EINER SILIKONPOLYMER-BESCHICHTUNG**
CIRCUIT CARRIER HAVING A SILICONE POLYMER COATING
SUPPORT D'INTERCONNEXION DOTÉ D'UN REVÊTEMENT DE POLYMÈRE SILICONE

(30) Priorität: 14.01.2014 DE 102014200492
(43) Veröffentlichungstag der Anmeldung: 23.11.2016
(73) Patentinhaber: Robert Bosch GmbH, 70442 Stuttgart (DE)
(72) Erfinder: FARIA, Isabel, 70806 Kornwestheim (DE); PFEIFFER, Peter, 71638 Ludwigsburg (DE); ELSINGER, Heiko, 75056 Sulzfeld (DE); HAHN, Andre, 70469 Stuttgart (DE)
(86) Internationale Anmeldenummer: PCT/EP2014/076248
(87) Internationale Veröffentlichungsnummer: WO 2015/106874

(56) Entgegenhaltungen:
- US-A1- 2008 226 902
- DATABASE WPI Week 200646 15. Juni 2006 (2006-06-15) Thomson Scientific, London, GB; AN 2006-448036 XP002734876, & JP 2006 152017 A (UBE IND LTD) 15. Juni 2006 (2006-06-15)

## Beschreibung

### Stand der Technik

Die Erfindung betrifft einen Schaltungsträger. Der Schaltungsträger weist wenigstens ein elektronisches Bauelement auf, wobei das elektronische Bauelement mit dem Schaltungsträger - insbesondere mittels eines Flussmittels - verlötet ist. Der Schaltungsträger weist eine insbesondere elektrisch isolierende Schutzschicht zum Betauungsschutz auf, wobei eine Oberfläche des Schaltungsträgers wenigstens teilweise mit der Schutzschicht bedeckt ist.

Zum Schutz von Leiterplatten sind aus dem Stand der Technik Silikonbeschichtungen bekannt, welche ausgebildet sind, die Leiterplatte, insbesondere elektrische Kontakte von Bauelementen, und Leiterbahnen der Leiterplatte, vor Feuchtigkeit und vor Verschmutzung zu schützen. Silikonpolymere, insbesondere als dünne Lackschicht oder als eine Vergussmasse bildende dicke Lackschicht, weisen dabei vorteilhaft eine hohe Temperaturbeständigkeit auf.

### Offenbarung der Erfindung

Erfindungsgemäß ist die Schutzschicht des Schaltungsträgers der eingangs genannten Art durch eine bevorzugt mittels Ultravioletter Strahlen aktivierbar ausgebildete Silikonpolymerschicht gebildet, wobei die Silikonpolymerschicht - insbesondere homogen - in der Silikonpolymerschicht verteilte Füllpartikel aufweist. Wenigstens ein Teil der Füllpartikel oder alle Füllpartikel weisen wenigstens ein Salz eines Erdalkalimetalls auf. Eine Matrix der Schutzschicht ist ein elastisch ausgebildetes vollvernetztes Silikongummi. Es wurde nämlich erkannt, dass die elektrischen Kontakte der Bauelemente trotz Verwendung einer Schutzschicht, welche durch einen Silikonlack gebildet ist, nachteiligerweise Korrosion ausbilden. Es wurde weiter erkannt, dass die erwähnte Korrosion durch polar wirkende Haftvermittler, als Bestandteil des Silikonlackes, verursacht wird. Weiter wurde erkannt, dass die Haftvermittler in Verbindung mit einer Wasserdampfdurchlässigkeit des Silikonlackes, eine Feuchtigkeitsakkumulation an einer Grenzfläche zwischen dem Silikonlack und der Leiterplatte herbeiführt, wo die Feuchtigkeit mit einem beim Verlöten des elektronischen Bauelements verbliebenen Flussmittelrestes eines Flussmittels, insbesondere als Bestandteil einer sogenannten Non-Clean-Lotpaste zusammenwirken kann. Weiter wurde erkannt, dass so im Flussmittelrest enthaltene Säuren und Ionen mit der zu der Grenzfläche migrierten Feuchtigkeit an den elektrischen Kontakten der elektronischen Bauelemente oder an Leiterbahnen des Schaltungsträgers, insbesondere an Kupfer-Leiterbahnen des Schaltungsträgers, die eingangs erwähnte Korrosion verursacht werden kann.

Überraschenderweise hat sich herausgestellt, dass die Füllpartikel, insbesondere im Falle eines Salzes oder eines Oxides eines Erdalkalimetalls, insbesondere Kalziumkarbonat, oder Aluminiumoxid, die Feuchtigkeitsmigration von außen durch die Schutzschicht hindurch, bis hin zum Schaltungsträger vorteilhaft reduzieren oder sogar verhindern können.

Bevorzugt beträgt ein Anteil der Füllpartikel wenigstens 5 Prozent, weiter bevorzugt zwischen 5 Prozent und 50 Prozent.

Dadurch kann vorteilhaft eine gute Dampfspernivirkung erzielt werden.

### Bevorzugt beträgt ein elektrischer Oberflächenwiderstand

Der Silikon-Schutzlack umfasst bevorzugt ein Basispolymer, insbesondere Polysilan, einen SI-H-Vernetzer, einen mittels ultravioletter Strahlen aktivierbar ausgebildeten Platinkatalysator und einen Silan-Haftvermittler.

Bevorzugt ist die Silikon-Polymerschicht durch eine additionsvernetzende Vergussmasse gebildet aus zwei Komponenten erzeugt, wobei die zwei Komponenten ausgebildet sind, in Abhängigkeit einer Exposition von ultravioletten Strahlen miteinander zu vernetzen. Eine Dichte der Polymerschicht beträgt beispielsweise 0,94 Gramm pro Kubikzentimeter, eine Shore-Härte 00 beträgt bevorzugt 40.

Bevorzugt ist das Silikonpolymer vinyl-terminiert, insbesondere Polyvinylsiloxan. Ein Vernetzungspolymer ist beispielsweise ein S-H-terminiertes Silikonpolymer, insbesondere Polyhydrogenmethylsiloxan.

Bevorzugt ist das Polymer, insbesondere Polymermoleküle in der Schutzschicht miteinander vollständig vernetzt, so dass anders als bei Silikon-Gelen - keine Flüssigkeit wie Wasser zwischen den Molekülen oder Molekülketten eingelagert ist.

Die bei Silikon-Gelen bestehende Eigen-Klebrigkeit geht bei dem Silikon-Schutzlack, insbesondere bei Silikon-Gummi als Schutzschichtbestandteil verloren, so dass zur Haftung an Bestandteilen des Schaltungsträgers wie des Substrates oder an Leiterbahnen, an Lotmittel oder an elektronischen Bauelementen der bereits erwähnte Haftvermittler beiträgt.

In einer bevorzugten Ausführungsform ist das zuvor erwähnte Salz ein Salz der Kohlensäure, insbesondere Karbonat oder Hydrogenkarbonat. Bevorzugt ist das Salz ausgewählt
aus der Gruppe umfassend Carbonate von Erdalkalimetallen und Aluminium. Weiter bevorzugt ist das Salz ausgewählt aus der Gruppe, umfassend Calciumcarbonat, insbesondere Kalk oder Kreide, Calciumhydrogencarbonat, Magnesiumcarbonat, Magnesiumhydrogencarbonat, Aluminiumcarbonat, Aluminiumhydrogencarbonat. Besonders bevorzugt ist das Karbonat Calciumcarbonat und/oder Magnesiumcarbonat.

Unabhängig oder zusätzlich zu den vorgenannten Füllpartikeln kann die Schutzschicht ein Salz umfassen, welches ausgewählt ist aus der Gruppe, umfassend wenigstens ein Metalloxid und/oder Metall-Hydroxid. Bevorzugt umfasst die Gruppe Calciumoxid, Calciumhydroxid, Magnesiumoxid,

Magnesiumhydroxid, Hydromagnesit, Hydrotalcit, Huntit, Aluminiumoxid, Aluminiumhydroxid und Glimmer.

Bevorzugt weisen die Füllpartikel eine Korngröße zwischen 0,1 Mikrometer und 100 Mikrometer auf, bevorzugt zwischen 0,1 und 10 Mikrometer. Bevorzugt sind die Füllpartikel hydrophobierte Füllpartikel, insbesondere oberflächlich hydrophobierte Füllpartikel. Die Füllpartikel bewirken vorteilhaft eine Reduzierung oder Verhinderung einer Feuchtigkeitsmigration durch die Schutzschicht hindurch bis hin zu dem Schaltungsträger. Die Matrix der Schutzschicht, insbesondere des Schutzlackes, ist ein elastisch ausgebildetes Silikongummi. Mittels des Silikongummis können vorteilhaft sowohl Leiterbahnen, welche mit dem Schaltungsträger verbunden sind, als auch Anschlüsse von elektronischen Bauelementen, welche sich quer zu einer flachen Erstreckung des Schaltungsträgers erstrecken, mittels einer ausreichend dick ausgebildeten Schutzschicht abgedeckt werden.

Beispielsweise kann eine Schichtdicke der Schutzschicht zwischen 5 und 2000 Mikrometer betragen, bei der elektrische Kontakte und Leiterbahnen elektrisch isoliert abgedeckt sind.

Weiter vorteilhaft kann der Schaltungsträger, insbesondere Bestandteile des Schaltungsträgers oder mit dem Schaltungsträger verbundene Bauelemente, bei thermischen Ausdehnungen nicht reißen, insoweit die Schutzschicht vorteilhaft elastisch ausgebildet ist und so bei thermisch verursachten Ausdehnungen von Bauelementen oder elektrischen Anschlüssen der Bauelemente, elastisch nachgeben kann.

In einer bevorzugten Ausführungsform weist der Silikonlack einen Haftvermittler auf. Der Haftvermittler ist beispielsweise Glymo, insbesondere 3-(2,3-Epoxypropoxy)propyltrimethoxysilane.

In einer bevorzugten Ausführungsform weisen die Füllpartikel oder wenigstens ein Teil der Füllpartikel wenigstens ein Oxid wenigstens eines Erdalkalimetalls auf. Die Füllpartikel weisen bevorzugt Magnesiumoxid, Kalziumoxid oder Aluminiumoxid auf.

In einer bevorzugten Ausführungsform sind wenigstens ein Teil der Füllpartikel an einer Grenzfläche der Schutzschicht zu dem Schaltungsträger hin angeordnet und sind ausgebildet, mit einer aus dem Flussmittel aus dem Schaltungsträger verbliebenen oder abgeschiedenen Säure, insbesondere unter Protolyse, die Säure abzubauen.

Der Schaltungsträger umfasst bevorzugt ein Substrat, beispielsweise eine Faserverstärkte Leiterplatte, insbesondere Epoxidharz-Leiterplatte, Leiterbahnen gebildet durch eine elektrisch leitfähige Schicht, insbesondere Kupferschicht, weiter bevorzugt Lötstopplack und mit den Leiterbahnen verbundenes Lotmittel, und das wenigstens eine elektronische Bauelement.

Vorteilhaft können so aufwandsgünstig bereitstellbare Füllpartikel aus Kalziumkarbonat mit der verbliebenen Säure, beispielsweise eine Karbonsäure, insbesondere Di-Karbonsäure, zu Kohlensäure protolysieren und so die für die elektrischen Kontakte und Anschlüsse schädliche Karbonsäure unter Abspaltung von Kohlendioxid abbauen.

Die Füllpartikel haben so vorteilhaft eine Doppelfunktion, nämlich die zuvor beschriebene Verhinderung von Feuchtigkeitsmigration durch die Schutzschicht hindurch und weiter im Falle einer Feuchtigkeitsmigration durch die Schutzschicht hindurch, einen Abbau der aus dem Flussmittel verbliebenen Säuren oder sauren Salze von Metallionen auf dem Schaltungsträger.

In einer bevorzugten Ausführungsform beträgt ein Volumenanteil der Füllpartikel in der Schutzschicht, insbesondere dem Silikon-Schutzlack, zwischen 2 Prozent und 50 Prozent, bevorzugt zwischen 5 Prozent und 30 Prozent. Volumenanteile von mehr als 50 Prozent der Füllpartikel in dem Silikonlack haben gezeigt, dass der Silikonlack zähpastös wird und so nur noch schwierig auf den Schaltungsträger aufgebracht werden kann.

In einer bevorzugten Ausführungsform sind die Füllpartikel in der Schutzschicht, insbesondere dem Silikonlack derart verteilt, dass der Schaltungsträger durch wenigstens einen Teil der Füllpartikel unmittelbar kontaktiert ist. So können die Füllpartikel, insbesondere Karbonate von Erdalkalimetallen, bevorzugt Kalziumkarbonate, besonders einfach in einen unmittelbaren Wirkkontakt mit dem Schaltungsträger und der dort verbliebenen oder abgeschiedenen Säure oder in einem auf dem Schaltungsträger durch Feuchtigkeitsmigration gebildeten Elektrolyten mit sauren Salzen geraten und so die Säure beziehungsweise die sauren Salze abbauen.

In einer bevorzugten Ausführungsform beträgt ein Durchmesser der Füllpartikel kleiner als fünf Mikrometer. So kann vorteilhaft eine hinreichende Fließfähigkeit des Silikonlackes beim Auftrag auf den Schaltungsträger erzielt werden, wobei der Silikonlack einen hohen Füllgrad der Füllpartikel aufweisen kann.

Die Erfindung betrifft auch ein Verfahren zum Erzeugen eines Schutzlackes für einen Schaltungsträger der vorbeschriebenen Art. Bei dem Verfahren wird ein UV-aktivierbar ausgebildeter Silikonlack mit - insbesondere bereits beschriebenen - Füllpartikeln gemischt und so als Mischungsprodukt ein partikelhaltiger Silikonlack erzeugt. Bevorzugt sind die Füllpartikel in dem Silikonlack gleichmäßig verteilt.

Die Erfindung betrifft auch ein Verfahren gemäß Anspruch 9 zum Erzeugen eines Schaltungsträgers, bei dem wenigstens ein elektronisches Bauelement mit dem Schaltungsträger mittels eines säurehaltigen oder säurefreisetzenden Flussmittels - insbesondere einer sogenannten Non-Clean-Lotpaste - verlötet wird. Der Schaltungsträger wird in einem Verfahrensschritt mittels eines Silikon-Schutzlackes beschichtet, wobei der Silikon-Schutzlack Füllpartikel umfassend ein Salz eines Erdalkalimetalls, insbesondere Kalkpartikel, mit einem Volumenanteil zwischen 2 und 50 Prozent umfasst.

Die Erfindung wird nun im Folgenden anhand von Figuren und weiteren Ausführungsbeispielen beschrieben. Weitere vorteilhafte Ausführungsvarianten ergeben sich aus den in den abhängigen Ansprüchen und den Figuren beschriebenen Merkmalen.
Figur 1 zeigt ein Ausführungsbeispiel für einen Schaltungsträger, bei dem ein Substrat und wenigstens elektrische Anschlüsse von mit dem Schaltungsträger verbundenen Bauelementen und Lötstellen mittels einer Feuchtigkeit transmittierend ausgebildeten Schutzschicht bedeckt sind;
Figur 2 zeigt eine Variante des in Figur 1 gezeigten Schaltungsträgers, bei dem die Schutzschicht für Feuchtigkeitstransmission hemmend ausgebildet ist;
Figur 3 zeigt ein Diagramm in dem Messwerte eines Versuchs zur Demonstration der Feuchtigkeitshemmemden Wirkung der Schutzschicht in Figur 2 dargestellt ist.

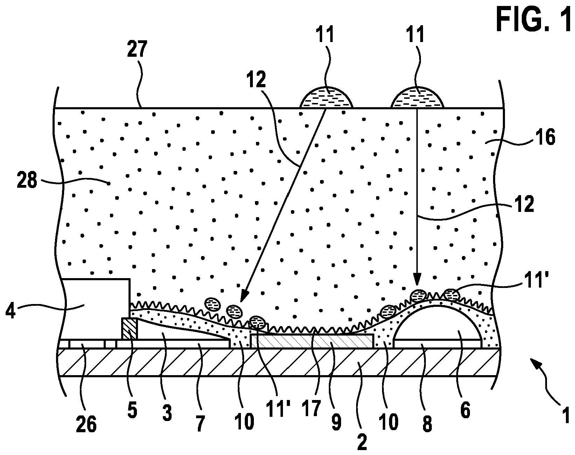

Figur 1 zeigt ein Ausführungsbeispiel für einen Schaltungsträger 1. Der Schaltungsträger 1 weist ein Substrat 2, insbesondere eine faserverstärkte Leiterplatte, auf. Der Schaltungsträger 1 weist auch ein mit der Leiterplatte 2 mittels eines Lotmittels 3 lötverbundenes elektronisches Bauelement 4 auf. Das elektronische Bauelement 4 ist in diesem Ausführungsbeispiel abschnittsweise dargestellt und ist beispielsweise durch einen integrierten Schaltkreis, insbesondere SMD-Baustein (SMD = Surface-Mounted-Device), gebildet.

Das elektronische Bauelement 4 weist einen elektrischen Anschluss 5 auf, welcher mittels des Lotmittels 3, insbesondere ein zinnhaltiges Lot, in diesem Ausführungsbeispiel im Reflow-Lötverfahren mit einer Leiterbahn 7 der Leiterplatte 2 verlötet ist. Das Bauelement 4 ist mittels eines Klebstoffs 26 mit der L eiterplatte 2 verklebt. Die Leiterplatte 2 weist neben der Leiterbahn 7 auch eine weitere Leiterbahn 8 auf, wobei ein Lotmittel, insbesondere Lotmitteltropfen 6, mit der Leiterbahn 8 lötverbunden ist.

Die Leiterbahnen 7 und 8 sind entlang einer flachen Erstreckung der Leiterplatte 2 zueinander beabstandet, wobei ein sich zwischen den Leiterbahnen 7 und 8 erstreckender Bereich der Leiterplatte 2 mittels eines Lötstopplackes 9 bedeckt ist.

Dargestellt ist auch ein Flussmittelrest 10, welcher in diesem Ausführungsbeispiel Karbonsäuren enthält.

Der Flussmittelrest 10 bedeckt in diesem Ausführungsbeispiel den elektrischen Anschluss 5, das Lotmittel 3 und das Lotmittel 6.

Die Leiterplatte 2 ist mittels eines Silikon-Schutzlackes 16 bedeckt. Sowohl das elektronische Bauelement 4 als auch die Lotmittel 3 und 6, welche sich jeweils von der Leiterplatte 2 abweisend erstrecken, sind mittels des Silikon-Schutzlackes 16 abgedeckt.

Auf einer Oberfläche 27 des Silikon-Schutzlackes 16 sind Wassertropfen 11 dargestellt, welche sich beispielsweise als kondensierter Wasserdampf als Folge einer Betauung der Leiterplatte 2 auf dem Silikon-Schutzlack 16 abgeschieden haben.

Figur 1 zeigt auch Pfeile 12, welche von den Wassertropfen 11 zu einer Grenzfläche 17 des Silikon-Schutzlackes zu der Leiterplatte 2 hin verlaufen. Die Pfeile 12 repräsentieren jeweils eine Wasserdampfmigration von den Wassertropfen 11 durch den Silikon-Schutzlack 16 hindurch, bis hin zur Grenzfläche 17, wo der transmigrierte Wasserdampf wieder als Wassertropfen 11' auskondensieren kann.

Die Transmigration wird in diesem Ausführungsbeispiel durch einen in dem Schutzlack 16 enthaltenen, polar wirkenden Haftvermittler 28 begünstigt oder bewirkt.

Die an der Grenzfläche 17 abgeschiedenen Wassertropfen wie der Wassertropfen 11' können mit den in dem Flussmittelrest 10 enthaltenen Salze und Säuren in den kondensierten Wassertropfen 11' dissoziieren und so gebildete Ionen sowohl mit dem Lotmittel 3 als auch dem elektrischen Anschluss 5 oder der Leiterbahn 7 zu einer als Korrosion bezeichneten Redoxreaktion führen.

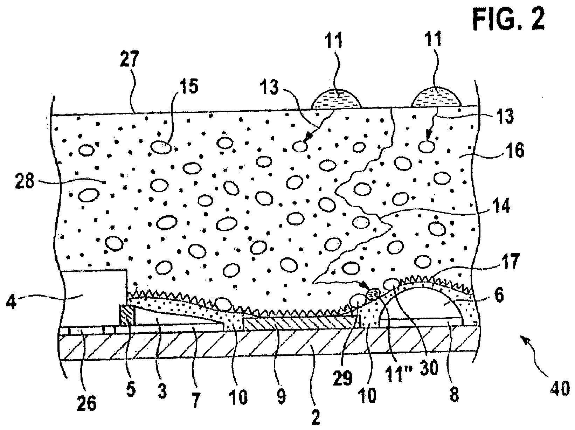

Figur 2 zeigt einen eine Variante des in Figur 1 bereits dargestellten Schaltungsträgers 1 bildenden Schaltungsträger 40, welcher gemäß der Erfindung im Vergleich zu dem Schaltungsträger 1 verbessert ist. Der Silikon-Schutzlack 16 weist einen Füllstoffanteil auf, wobei der Füllstoff durch Füllstoffpartikel, insbesondere Caliumcarbonat-Partikel, und/oder Aluminiumoxid-Partikel gebildet ist, von denen ein Füllstoffpartikel 15 beispielhaft bezeichnet ist.

Die auf der Oberfläche 27 kondensierten Wassertropfen 11 können - angedeutet durch die Pfeile 13 - bis hin zu den polar wirkenden Füllpartikeln 15 migrieren, wobei die Füllpartikel 15 für die Migration 13 eine Barriere repräsentieren. Die Füllpartikel 15 bilden auch vorteilhaft eine Vermeidung eines großen Polaritätsunterschiedes zwischen einer Matrix des Silikonlackes 16 und der Grenzfläche 17 zu der Leiterplatte 2 hin.

Ein Migrationsweg 14 repräsentiert einen kleinen Anteil Wasserdampf aus den Wassertropfen 11, welcher - an den Füllpartikeln 15 vorbei - durch den Silikonlack 16, bis hin zur Grenzfläche 17, migriert und dort als kondensierter Wassertropfen 11" auskondensiert ist.

Dargestellt sind auch zwei Füllpartikel 29 und 30, welche wie das Füllpartikel 15 ausgebildet sind, aber im Unterschied zu den Füllpartikeln 15 wenigstens teilweise die Grenzfläche 17 bilden und so die Leiterplatte 2, insbesondere die mit der Leiterplatte 2 verbundenen und von der Leiterplatte 2 sich abweisend erstreckenden Komponenten wie die Lötmittel 3 und 6 den Lötstopplack 9, aber auch den Flussmittelrest 10 unmittelbar kontaktieren können. Die Füllpartikel 29 und 30, welche wie die Füllpartikel 15 in diesem Ausführungsbeispiel als Kalkpartikel ausgebildet sind, können mit dem in den kondensierten Wassertropfen 11" von der Säure des Flussmittelrestes 10 gebildeten Hydroxonium-Ionen eine Protolyse eingehen und so für die elektrischen Kontakte vergleichsweise harmlose Kohlensäure ausbilden.

Die Kohlensäure, insbesondere durch weitere Wasserabspaltung entstehendes Kohlendioxid, kann wie der Wasserdampf in den Schutzlack 16 diffundieren. Der Schutzlack 16 weist dazu bevorzugt eine Permeabilität für Kohlensäure, insbesondere Kohlendioxid, auf.

Figur 3 zeigt ein Diagramm 18. Das Diagramm 18 zeigt auf einer Abszisse 19 Messbalken, welche jeweils einen Messwert für einen Oberflächenwiderstand des in Figur 2 dargestellten Schaltungsträgers repräsentieren.

Es wurden zueinander verschiedene Schutzschichten hinsichtlich ihres Oberflächenwiderstandes und ihrer Feuchtigkeitstransmission untersucht, wobei die zueinander verschiedene Schutzschichten zueinander verschiedene Anteil von Füllpartikeln in einem Silikon-Schutzlack aufweisen.

Der Silikon-Schutzlack ist Semicosil ® 949 der Fa. Wacker Chemie, die Füllpartikel sind Calciumcarbonat-Partikel Winnofil ® SPM der Fa. Solvay.

Der Oberflächenwiderstand wurde mittels einer Vierpunktmessung, insbesondere gemäß einer Prüfnorm IEC 61189-5 über einen Zeitraum von 520 Stunden ermittelt.

Der Messwert 21 repräsentiert einen Schaltungsträger mit einem Silikon-Schutzlack 16, welcher keinen Haftvermittler wie den in Figur 2 dargestellten Haftvermittler 28, und keine Füllpartikel, wie die in Figur 2 dargestellten fünf Füllpartikel 15 aufweist. Ein Oberflächenwiderstand des so ausgebildeten Schutzlackes 16 ist vergleichsweise gut und beträgt in diesem Ausführungsbeispiel mehr als 500 Megaohm. Eine gestrichelte Linie 31 repräsentiert einen Oberflächenwiderstand von 500 Megaohm, welcher auf einer Ordinate 20 des Diagramms 18 aufgetragen ist.

Ein Messwert 22 repräsentiert ein Substrat wie das Substrat 2 in Figur 2, wobei der Silikon-Schutzlack 16 einen Haftvermittler wie den Haftvermittler 28 aufweist, jedoch keine Füllpartikel wie die Füllpartikel 15. Ein Oberflächenwiderstand des Silikon-Schutzlackes 16 beträgt hier nur 1000 Ohm.

Ein Messwert 23 repräsentiert einen Schaltungsträger wie den Schaltungsträger 1 in Figur 2, mit einem Anteil an Füllpartikeln 15 von fünf Prozent in dem Silikon-Schutzlack 16. Sichtbar ist ein deutlicher Anstieg des Oberflächenwiderstandes, auf 100 Kiloohm, im Vergleich zum Messwert 22. Der Messwert 24 repräsentiert einen Schaltungsträger wie den Schaltungsträger 1 in Figur 2, bei dem der Silikon-Schutzlack 16 einen Füllpartikelanteil der Füllpartikel 15 von zehn Prozent aufweist. Sichtbar ist, dass ein für Elektronikanwendungen bereits guter Mindest-Widerstandswert von 500 Megaohm mit zehn Prozent Füllpartikeln in der Schutzschicht bereits erreicht wird.

Der Messwert 25 repräsentiert einen Schaltungsträger wie den Schaltungsträger 1 in Figur 2, wobei die Schutzschicht, gebildet durch den Silikon-Schutzlack 16, einen Füllpartikelanteil der Füllpartikel 15 von 30 Prozent aufweist. Sichtbar ist, dass der Widerstandswert des Oberflächenwiderstandes weiter auf mehr als 10 Gigaohm verbessert werden konnte, was überraschenderweise den Messwert 21 übertraf. Die Schichtdicke des Silikon-Schutzlackes 16, an denen die in Figur 3 dargestellten Messwerte ermittelt wurden, betrug 300 Mikrometer.

Eine Expositionsdauer des Silikon-Schutzlackes 16 gegenüber der Feuchtigkeit, wie den in Figur 2 dargestellten Wassertropfen 11, betrug wenigstens 500 Stunden.

## Patentansprüche

1. Schaltungsträger (1, 40) mit wenigstens einem elektronischen Bauelement (4), wobei das elektronische Bauelement (4) mit dem Schaltungsträger (1, 40), insbesondere einer Leiterbahn (7, 8) des Schaltungsträgers (1), mittels eines Flussmittels (10) verlötet ist, wobei der Schaltungsträger (1) eine Schutzschicht (16) zum Betauungsschutz aufweist, wobei eine Oberfläche des Schaltungsträgers (1, 40) wenigstens teilweise mit der Schutzschicht (16) bedeckt ist,
**dadurch gekennzeichnet, dass**
die Schutzschicht (16) durch eine Silikonpolymerschicht gebildet ist, wobei die Silikonpolymerschicht (16) homogen in der Silikonpolymerschicht (16) verteilte Füllpartikel (15) aufweist, wobei die Füllpartikel (15) wenigstens ein Salz eines Erdalkalimetalls aufweisen, und dass
eine Matrix der Schutzschicht (16) ein elastisch ausgebildetes vollvernetztes Silikongummi ist.

2. Schaltungsträger (1, 40) nach Anspruch 1,
**dadurch gekennzeichnet, dass**
das Salz ein Salz der Kohlensäure, insbesondere Carbonat oder Hydrogencarbonat ist.

3. Schaltungsträger (1, 40) nach Anspruch 1 oder 2,
**dadurch gekennzeichnet, dass**
die Schutzschicht (16) einen Haftvermittler (28) aufweist.

4. Schaltungsträger (1, 40) nach einem der vorhergehenden Ansprüche,
**dadurch gekennzeichnet, dass**
die Füllpartikel (15) oder wenigstens ein Teil der Füllpartikel (15) wenigstens ein Oxid wenigstens eines Erdalkalimetalls aufweisen.

5. Schaltungsträger (1, 40) nach einem der vorhergehenden Ansprüche,
**dadurch gekennzeichnet, dass**
wenigstens ein Teil der Füllpartikel (15) an einer Grenzfläche (17) der Schutzschicht (16) zu dem Schaltungsträger (1, 40) hin angeordnet sind und ausgebildet sind, mit einer aus dem Flussmittel (10) auf dem Schaltungsträger (1, 40) verbliebene oder abgeschiedene Säure insbesondere unter Protolyse die Säure abzubauen.

6. Schaltungsträger (1, 40) nach einem der vorhergehenden Ansprüche,
**dadurch gekennzeichnet, dass**
ein Volumenanteil der Füllpartikel (28) in der Schutzschicht (16) zwischen 5 und 50 Prozent beträgt.

7. Schaltungsträger (1, 40) nach einem der vorhergehenden Ansprüche 5 oder 6,
**dadurch gekennzeichnet, dass**
die Füllpartikel (28) in der Schutzschicht (16) derart verteilt sind, dass der Schaltungsträger (1, 40) durch wenigstens einen Teil der Füllpartikel (28) unmittelbar kontaktiert ist.

8. Schaltungsträger (1, 40) nach einem der vorhergehenden Ansprüche,
**dadurch gekennzeichnet, dass**
ein Durchmesser der Füllpartikel (28) kleiner als 5 Mikrometer beträgt.

9. Verfahren zum Erzeugen eines Schaltungsträgers (1, 40), bei dem wenigstens ein elektronisches Bauelement (4) mit dem Schaltungsträger (1, 40) mittels eines Säurehaltigen oder Säure freisetzenden Flussmittels (10) verlötet wird, und der Schaltungsträger (1, 40) mittels einer Schutzschicht (16), nämlich eines Silikon-Schutzlackes, beschichtet wird, wobei der Silikon-Schutzlack Füllpartikel (28) umfassend ein Salz eines Erdalkalimetalls, insbesondere Kalkpartikel, mit einem Volumenanteil zwischen 10 und 50 Prozent umfasst, und wobei
eine Matrix der Schutzschicht (16) ein elastisch ausgebildetes vollvernetztes Silikongummi ist.

## Claims

1. Circuit carrier (1, 40) with at least one electronic component (4), the electronic component (4) being soldered to the circuit carrier (1, 40), in particular a strip conductor (7, 8) of the circuit carrier (1), by means of a flux (10), the circuit carrier (1) having an anti-condensation protective layer (16), a surface of the circuit carrier (1, 40) being at least partially covered with the protective layer (16),
**characterized in that**
the protective layer (16) is formed by a silicone polymer layer, the silicone polymer layer (16) comprising filler particles (15) homogeneously distributed in the silicone polymer layer (16), the filler particles (15) comprising at least one salt of an alkaline earth metal, and **in that**
a matrix of the protective layer (16) is an elastically formed fully crosslinked silicone rubber.

2. Circuit carrier (1, 40) according to Claim 1,
**characterized in that**
the salt is a salt of carbonic acid, in particular carbonate or hydrocarbonate.

3. Circuit carrier (1, 40) according to Claim 1 or 2,
**characterized in that**
the protective layer (16) comprises an adhesion promoter (28).

4. Circuit carrier (1, 40) according to one of the preceding claims,
**characterized in that**
the filler particles (15) or at least some of the filler particles (15) comprise at least one oxide of at least one alkaline earth metal.

5. Circuit carrier (1, 40) according to one of the preceding claims,
**characterized in that**
at least some of the filler particles (15) are arranged at an interface (17) of the protective layer (16) with the circuit carrier (1, 40) and are designed to work with an acid remaining or deposited from the flux (10) on the circuit carrier (1, 40) to break down the acid, in particular by a proton-transfer reaction.

6. Circuit carrier (1, 40) according to one of the preceding claims,
**characterized in that**
a proportion by volume of the filler particles (28) in the protective layer (16) is between 5 and 50 percent.

7. Circuit carrier (1, 40) according to either of the preceding Claims 5 and 6,
**characterized in that**
the filler particles (28) are distributed in the protective layer (16) in such a way that the circuit carrier (1, 40) is directly contacted by at least some of the filler particles (28).

8. Circuit carrier (1, 40) according to one of the preceding claims,
**characterized in that**
a diameter of the filler particles (28) is less than 5 micrometers.

9. Method for creating a circuit carrier (1, 40), in which at least one electronic component (4) is soldered to the circuit carrier (1, 40) by means of an acid-containing or acid-releasing flux (10), and the circuit carrier (1, 40) is coated by means of a protective layer (16), specifically a silicone protective varnish, the silicone protective varnish comprising filler particles (28) comprising a salt of an alkaline earth metal, in particular calcium carbonate particles, with a proportion by volume of between 10 and 50 percent, and
a matrix of the protective layer (16) being an elastically formed fully crosslinked silicone rubber.

## Revendications

1. Support de circuit (1, 40) comportant au moins un composant électronique (4), dans lequel le composant électronique (4) est soudé au support de circuit (1, 40), en particulier à un trajet conducteur (7, 8) du support de circuit (1), au moyen d'un flux (10), dans lequel le support de circuit (1) présente une couche protectrice (16) pour la protection contre la condensation, dans lequel une surface du support de circuit (1, 40) est au moins partiellement revêtue de la couche protectrice (16),
**caractérisé en ce que** la couche protectrice (16) est formée par une couche de polymère silicone, dans lequel la couche de polymère silicone (16) comporte des particules de charge (15) réparties de manière homogène dans la couche de polymère silicone (16), dans lequel les particules de charge (15) comprennent au moins un sel d'un métal alcalino-terreux, et
**en ce qu'**une matrice de la couche protectrice (16) est un caoutchouc silicone entièrement réticulé réalisé de manière élastique.

2. Support de circuit (1,40) selon la revendication 1,
**caractérisé en ce que** le sel est un sel d'acide carbonique, en particulier un carbonate ou un hydrogénocarbonate.

3. Support de circuit (1, 40) selon la revendication 1 ou 2,
**caractérisé en ce que** la couche protectrice (16) comporte un promoteur d'adhérence (28).

4. Support de circuit (1, 40) selon l'une des revendications précédentes,
**caractérisé en ce que** les particules de charge (15) ou au moins une partie des particules de charge (15) comprennent au moins un oxyde d'au moins un métal alcalino-terreux.

5. Support de circuit (1, 40) selon l'une des revendications précédentes,
**caractérisé en ce qu'**au moins une partie des particules de charge (15) sont disposées sur une surface d'interface (17) de la couche de protection (16) par rapport au support de circuit (1, 40) et sont conçues pour dégrader l'acide au moyen d'un acide restant ou se déposant à partir du flux (10) sur le support de circuit (1, 40), en particulier sous protolyse.

6. Support de circuit (1, 40) selon l'une des revendications précédente,
**caractérisé en ce qu'**une fraction volumique des particules de charge (28) dans la couche protectrice (16) est comprise entre 5 et 50 pour cent.

7. Support de circuit (1, 40) selon l'une des revendications 5 ou 6 précédentes,
**caractérisé en ce que** les particules de charge (28) sont réparties dans la couche protectrice (16) de manière à ce que le support de circuit (1, 40) soit directement en contact avec au moins une partie des particules de charge (28).

8. Support de circuit (1, 40) selon l'une des revendications précédentes,
**caractérisé en ce qu'**un diamètre des particules de charge (28) est inférieur à 5 micromètres.

9. Procédé de fabrication d'un support de circuit (1, 40), dans lequel au moins un composant électronique (4) est soudé au support de circuit (1, 40) au moyen d'un flux (10) contenant un acide ou libérant un acide, et le support de circuit (1, 40) est revêtu au moyen d'une couche protectrice (16), à savoir un vernis protecteur de silicone, dans lequel le vernis protecteur de silicone comprend des particules de charge (28) comprenant un sel d'un métal alcalino-terreux, en particulier des particules de calcaire, ayant une teneur en volume comprise entre 10 et 50 pour cent, et dans lequel une matrice de la couche protectrice (16) est un caoutchouc silicone entièrement réticulé réalisé de manière élastique.
